# EUROPÄISCHE PATENTSCHRIFT

(11) **EP 3 197 848 B1**
(45) Veröffentlichungstag und Bekanntmachung des Hinweises auf die Patenterteilung: **27.02.2019**
(21) Anmeldenummer: 15750788.0
(22) Anmeldetag: 19.08.2015
(51) Int. Cl.: G01L 9/00, G01F 1/34, C04B 37/00, B22D 11/06

(54) **VERFAHREN ZUM HERSTELLEN EINER VERBINDUNG ZWISCHEN ZWEI KERAMIKTEILEN, INSBESONDERE VON TEILEN EINES DRUCKSENSORS**
PROCESS FOR JOINING CERAMIC PARTS, ESPECIALLY PRESSURE SENSOR PARTS
PROCEDE POUR JOINDRE DEUX PIECES CERAMIQUES, DE PREFERENCE DES PIECES D'UNE SONDE DE PRESSION

(30) Priorität: 26.09.2014 DE 102014113958
(43) Veröffentlichungstag der Anmeldung: 02.08.2017
(73) Patentinhaber: Endress+Hauser SE+Co. KG, 79689 Maulburg (DE)
(72) Erfinder: DREWES, Ulfert, 79379 Müllheim (DE); PONATH, Nils, 79539 Lörrach (DE); ROSSBERG, Andreas, 79713 Bad Säckingen (DE); THAM, Anh Tuan, 14089 Berlin (DE)
(74) Vertreter: Andres, Angelika Maria
(86) Internationale Anmeldenummer: PCT/EP2015/069074
(87) Internationale Veröffentlichungsnummer: WO 2016/045884

(56) Entgegenhaltungen:
- EP-A1- 0 215 554
- DE-A1-102010 043 119
- Kyu-Yong Lee: "Brazing Ceramic to Stainless Steel Enhanced by Surface Modification", Welding Journal, 1. September 2007 (2007-09-01), XP055228835, Gefunden im Internet: URL:https://app.aws.org/bsmc/wj200709_35.p df [gefunden am 2015-11-17]

## Beschreibung

Die vorliegende Erfindung betrifft ein Verfahren zum Herstellen einer Verbindung zwischen zwei Keramikteilen, insbesondere von Teilen eines Drucksensors und ein keramisches Produkt, insbesondere einen keramischen Drucksensor.

Keramische Drucksensoren umfassen einen Grundkörper und eine Messmembran, wobei die Messmembran mittels eines Aktivhartlots gefügt ist. Ein geeignetes Aktivhartlot zum Fügen von Keramikteilen aus Korund ist beispielsweise eine Zr-Ni-Ti-Legierung, da diese von ihrem Wärmeausdehnungskoeffizienten mit Korund kompatibel ist.

Im Europäischen Patent EP 0 490 807 B1 ist ein solches Aktivhartlot offenbart. Die Patentschrift EP 0 558 874 B1 offenbart ein Verfahren zum Herstellen von Ringen aus einem solchen Aktivhartlot, Ringe aus Aktivhartlot werden zum Verbinden von Messmembran und den Grundkörper als Abstandhalter zwischen die beiden Teile gelegt, und in einem Hochvakuumlötprozess aufgeschmolzen, wodurch eine druckdichte und hochfeste ringförmige Verbindung zwischen den beiden Keramikteilen entsteht. Eine alternative zum Aufbringen des Lots in Form von vorgefertigten Ringen besteht darin, das Aktivhartlot in einem Siebdruckverfahren bereitzustellen. Eine siebdruckfähige Paste des Aktivhartlots und ein Verfahren zu deren Herstellung ist in der Offenlegungsschrift EP 0 988 919 A1 offenbart.

Die Ringe lassen sich jedoch nur in einer Mindeststärke von etwa 30 µm in reproduzierbarer Qualität herstellen und auch die siebdruckfähige Paste weist Körnungen auf die im Ergebnis zu Fügestellen mit einer Mindeststärke von etwa 30 µm zwischen den Keramikteilen führen.

Aus dem Wunsch zur Miniaturisierung von Drucksensoren folgt indirekt der Bedarf nach einer dünneren Fügestelle, da - beispielsweise bei einem keramischen Drucksensor mit einem kapazitiven Wandler- die Miniaturisierung zu einer Verkleinerung der Elektrodenflächen des kapazitiven Wandlers führt, die dann durch eine Verringerung des Abstands zu kompensieren ist.

EP 0 215 554 A1 offenbart Aktivhartlotlegierungen, die keramische Elemente gegenseitig oder ein keramisches Element und ein metallisches Element miteinander mit hoher Verbindungsfestigkeit und verbesserter Verfügbarkeit verbinden können. Die Aktivhartlote können beispielsweise durch Sputtern von einem Target abgeschieden werden, welches die Legierung enthält.

Die Offenlegungsschrift DE 10 2010 043 119 A1 offenbart ein Verfahren zum Herstellen einer Verbindung zwischen zwei Oberflächen oder Oberflächenabschnitten zweier Keramikteile bei welchem das gesamte Aktivhartlotmaterial zum Verbinden des ersten und des zweiten Keramikteils in der Weise bereitgestellt wird, dass ein Oberflächenabschnitt eines oder beider Keramikteile, mittels einer Gasphasenabscheidung mit der Legierung des Aktivhartlots und/oder deren Komponenten beschichtet wird. Die Gasphasenabscheidung kann dabei beispielsweise mittels Sputtern bzw. Kathodenzerstäubung erfolgen. Das Sputtertarget, welches die Legierung des Aktivhartlots in der Sollzusammensetzung enthält, kann beispielsweise pulvermetallurgisch hergestellt sein. Die pulvermetallurgische Herstellung solcher Targets ist jedoch aufwändig, insbesondere dann, wenn die Targets aktive Komponenten enthalten. Dies erfordert dann Zerkleinerungs- und Mahlprozesse unter Wasserstoffatmosphäre.

Es ist daher die Aufgabe der vorliegenden Erfindung, ein alternatives Verfahren bereitzustellen, welches die Nachteile des Stands der Technik überwindet.

Die Aufgabe wird erfindungsgemäß gelöst durch das Verfahren gemäß Patentanspruch 1.

Das erfindungsgemäße Verfahren zum Herstellen einer Verbindung zwischen zwei Oberflächen oder Oberflächenabschnitten zweier Keramikteile umfasst: Bereitstellen eines ersten Keramikteils und eines zweiten Keramikteils; Bereitstellen eines Aktivhartlotmaterials auf zumindest einem Oberflächenabschnitt zumindest eines der Keramikteile, wobei das Aktivhartlot eine Zr-Ni-Ti-Legierung aufweist; und Erhitzen das Aktivhartlots in einem Vakuumlötprozess, wobei das gesamte Aktivhartlotmaterial zum Verbinden des ersten und des zweiten Keramikteils durch ein Sputter-verfahren bereitgestellt wird, wobei zumindest ein Oberflächenabschnitt zumindest eines der Keramikteile, vorzugsweise beider Keramikteile, mit einer Schichtfolge der einzelnen Komponenten des Aktivhartlotmaterials beschichtet wird, wobei Zr, Ni, und Ti jeweils eine der einzelnen Komponenten bilden, wobei die mittlere Stärke der Schichten einer einzelnen Komponente des Aktivhartlots nicht mehr als 0,5 %, insbesondere nicht mehr als 0,2%, vorzugsweise nicht mehr als 0,1% und besonders bevorzugt nicht mehr als 0,05% der Stärke der Fügestelle beträgt.

Das Aktivhartlot in der Fügestelle weist in einer Weiterbildung der Erfindung eine Stärke von nicht mehr als 20 µm, insbesondere nicht mehr als 15 µm, bevorzugt nicht mehr als 12 µm und besonders bevorzugt nicht mehr als 10 µm auf.

Gemäß einer Weiterbildung der Erfindung weisen die einzelnen Schichten der Komponente eine Stärke von nicht mehr als 10 nm, insbesondere nicht mehr als 5 nm, vorzugsweise nicht mehr als 2 nm und besonders bevorzugt nicht mehr als 1 nm auf.

In einer Weiterbildung der Erfindung ist die mittlere Schichtstärke der Schichten einer Komponente und/oder deren Häufigkeit eine Funktion des Anteils der Komponente an der Legierung.

In einer Weiterbildung der Erfindung ist die mittlere Schichtstärke der Schichten einer Komponente und proportional zum Anteil der Komponente an der Legierung.

In einer Weiterbildung der Erfindung werden die Komponenten jeweils von reinen Sputtertargets gesputtert, die jeweils ausschließlich das Material der Komponente aufweisen.

In einer Weiterbildung der Erfindung wird die Stärke der einzelnen Schichte über die Zeit in Abhängigkeit von der Depositionsrate der einzelnen Komponenten gesteuert.

In einer Weiterbildung der Erfindung wird die Depositionsrate mittels einer Quarzwaage überwacht.

In einer Weiterbildung der Erfindung wird auf der mindestens einen Oberfläche zunächst eine erste Schichtfolge einer ersten Zusammensetzung der Komponenten des Aktivhartlots abgeschieden, wobei auf die erste Schichtfolge eine zweite Schichtfolge einer zweiten Zusammensetzung des Aktivhartlots folgt.

In einer Weiterbildung der Erfindung weist die erste Schichtfolge eine Stärke aufweist, die nicht mehr als 10% insbesondere nicht mehr als 5% der Stärke der Fügestelle beträgt.

In einer Weiterbildung der Erfindung weist die erste Zusammensetzung einen Schmelzpunkt auf, der nicht weniger als 100K niedriger ist als der Schmelzpunkt der zweiten Zusammensetzung.

In eine Weiterbildung der Erfindung weist die zweite Zusammensetzung einen Wärmeausdehnungskoeffizenten auf, der eine geringere Differenz zum Wärmeausdehnungskoeffizienten des keramischen Werkstoffs aufweist als der Wärmeausdehnungskoeffizient der ersten Zusammensetzung.

Gemäß einer Weiterbildung weist die erste Schicht, mit welcher zumindest eine der Fügepartner beschichtet wird, eine aktive Komponente des Aktivhartlots auf.

Gemäß einer Weiterbildung der Erfindung umfasst das Aktivhartlot eine Zr-Ni-Ti-Legierung, wobei die mindestens eine aktive Komponente, insbesondere Titan oder Zirkon umfasst.

Gemäß einer Weiterbildung der Erfindung umfasst das erste und/oder zweite Keramikteil Korund.

Gemäß einer Weiterbildung der Erfindung werden das erste Keramikteil und das zweite Keramikteil entlang einer ringförmigen Fügestelle, welche einen Hohlraum zwischen dem ersten Keramikteil und dem zweiten Keramikteil umschließt, druckdicht verbunden, wobei das Aktivhartlot auf mindestens einem ringförmigen Oberflächenabschnitt eines Keramikteils abgeschieden wird, wobei ein von dem ringförmigen Oberflächenabschnitt umschlossener Bereich während des Abscheidens des Aktivhartlots maskiert ist.

In einer Weiterbildung der Erfindung ist der Lötprozess ein Vakuumlötprozess oder ein Lötprozess unter Schutzgas.

In einer Weiterbildung der Erfindung umfasst das erste keramische Teil einen Grundkörper des Drucksensors, wobei das zweite keramische Teil die Messmembran des Drucksensors umfasst, und wobei die Messmembran mit dem Grundkörper entlang einer ringförmigen Fügestelle, welche das Aktivhartlot aufweist, druckdicht verbunden ist.

In einer Weiterbildung der Erfindung ist der Drucksensor ein Differenzdrucksensor, welcher eine Messmembran zwischen zwei Grundkörpern oder einen Grundkörper zwischen zwei Messmembranen aufweist, die miteinander zu fügen sind, wobei das Aktivhartlotmaterial für die beiden Fügestellen zwischen der Messmenbran und den Gegenkörpern bzw. den Messmembranen und dem Gegenkörper jeweils in gleicher Weise bereitgestellt wird.

Die Erfindung wird nun anhand des in der Zeichnung dargestellten Ausführungsbeispiels erläutert.

Es zeigt:
- Fig. 1:: Komponenten eines keramischen Drucksensors, welche mittels des erfindungsgemäßen Verfahrens gefügt werden;
- Fig. 2a:: Ein Flussdiagramm eines Ausführungsbeispiels des erfindungsgemäßen Verfahrens; und
- Fig. 2b:: Ein detaillierteres Flussdiagramm zur Durchführung eines Verfahrensschrittes des Ausführungsbeispiels aus Fig. 2a

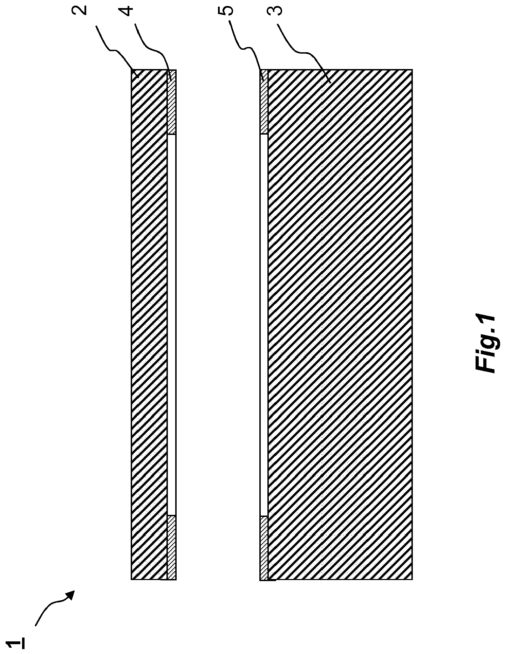

Die in Fig 1. dargestellten Komponenten eines keramischen Drucksensors 1 umfassen eine kreisscheibenförmige Messmembran 2 einen kreisscheibenförmigen Grundkörper 3, welche Korund aufweisen. Insbesondere die Messmembran kann hochreines Korund mit einer Reinheit von besser als 99,98 % aufweisen. Die Messmembran 1 und der Grundkörper 2 weisen, je nach Ausgestaltung beispielsweise einen Durchmesser von etwa 15 bis 25 mm auf. Die Materialstärke der Messmembran 2 beträgt beispielsweise 100 µm bis 2 mm, während der Grundkörper eine Materialstärke von einigen mm aufweist. Die genannten Abmessungen sind jedoch keine erfindungswesentliche Größe und können beispielsweise nach messtechnischen Erfordernissen oder anderen Randbedingungen gewählt werden. Die Messmembran 1 und der Grundkörper 2 sind mittels eines Zr-Ni-Ti-Aktivhartlots in einem Hochvakuumlötprozess druckdicht zu verbinden.

Hierzu werden die zu fügenden Stirnflächen der Messmembran 2 und des Grundkörpers 3 zunächst jeweils bis auf einen ringförmigen Randbereich maskiert, um dann das Aktivhartlot für die Fügestelle in dem ringförmigen Randbereich mittels Gasphasenabscheidung zu präparieren.

Nach dem vollständigen Abscheiden des Aktivhartlots zum Bilden der Fügestelle werden die Messmembran 2 und der Grundkörper 3 mit den Aktivhartlotbeschichtungen aufeinandergelegt und in einem Vakuumlötprozess miteinander druckdicht verbunden.

Vorzugsweise werden vor dem Abscheiden des Aktivhartlots (hier nicht dargestellte) Elektroden für einen kapazitiven Wandler des Drucksensors präpariert. Dies kann ebenfalls mittels Gasphasenabscheidung in einem Sputter-Verfahren erfolgen. Als Elektrodenmaterial ist beispielsweise Ta geeignet, welches in einer Stärke von beispielsweise 0,1 bis 0,2 µm abgeschieden wird. Eine bevorzugte Elektrodenanordnung kann beispielsweise eine Bildung eines Differentialkondensators ermöglichen, wozu auf der Stirnseite des Grundkörpers in dem von der ringförmigen Fügestelle zu umschließenden Bereich eine zentrale, kreisflächenförmige Messelektrode und eine diese umgebende, kapazitätsgleiche, ringförmige Referenzelektrode abgeschieden wird. Die Messelektrode, die Referenzelektrode und die Fügestelle sind beim fertigen Drucksensor vorzugsweise gegeneinander elektrisch isoliert. Auf der Membran wird vorzugsweise eine vollflächige Gegenelektrode präpariert, welche vorzugsweise beim fertigen Sensor mit der Fügestelle im galvanischen Kontakt steht.

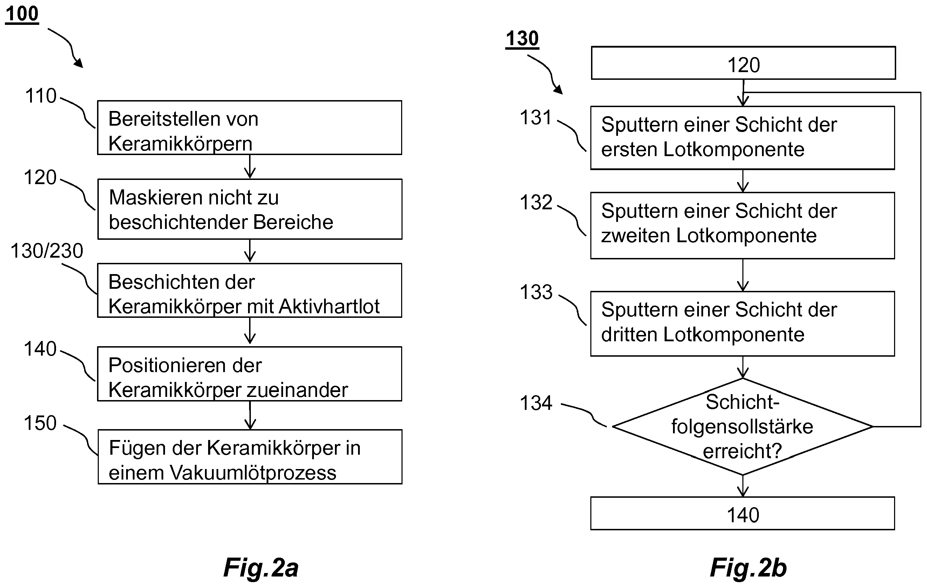

Ein Ausführungsbeispiel eines Verfahrens zum Herstellen einer Verbindung zwischen Keramikkörpern, beispielsweise der obigen Komponenten eines Drucksensors, wird nun anhand der Fign. 2a bis 2b erläutert. Hierbei zeigt Fig. 2a zunächst allgemein ein an sich bekanntes Verfahren 100 mit einer Schrittfolge welche das Bereitstellen 110 von Keramikkörpern, Maskieren 120 nicht zu beschichtender Bereiche, Beschichten 130 der Keramikkörper mit Aktivhartlot, Positionieren 140 der Keramikkörper zueinander, und Fügen 150 der Keramikkörper in einem Vakuumlötprozess umfasst. Die Besonderheit der vorliegenden Erfindung betrifft das Beschichten 130, welches im Einzelnen in Fig. 2b dargestellt ist. Demnach erfolgt das Beschichten 130 durch eine wiederholte Folge von Sputterschritten 131, 132, 133 bis eine gewünschte Schichtfolgenstärke von beispielsweise 5 µm erreicht ist, wobei die maximale Einzelschichtstärke beispielsweise etwa 5 nm beträgt. So können die Schichten einer ersten Komponente beispielsweise eine Schichtstärke von 1 nm, die Schichten einer zweiten Komponente eine Stärke von 2 nm und die Schichten einer dritten Komponente beispielsweise eine Stärke von 5 nm aufweisen.

Die Stärke der einzelnen Schichten wird bei Sputtern über die komponentenspezifische elektrische Leistung und die Sputterzeit gesteuert, wobei in die Depositionsrate bei gegebener Leistung die Atommasse und die Dichte der Komponente eingehen.

Es gibt jedoch durchaus Legierungen, die sich bei gleicher Häufigkeit der Schichten der einzelnen Komponenten nicht mehr vernünftig durch eine Variation der Schichtdicke darstellen lassen. So gilt für die Komponenten c_{Zr}, c_{Ni}, c_{Ti} einer bevorzugten Zr-Ni-Ti-Legierung (in Atom-%): 61 < c_{Zr} < 63,5; 21,5 < c_{Ni} < 24 und 14,5 < c_{Ti} <15,5.

Unter Berücksichtigung der jeweiligen Atommassen und Festkörperdichten der reinen Materialien ergeben sich damit für eine Zusammensetzung (in Atom-%) mit c_{Zr} = 62; c_{Ni} =23 und c_{Ti} =15 die folgenden Schichtstärkenverhältnisse:
d_{Zr} = 5 nm; d_{Ni} = 1,0 nm und d_{Ti} = 0,4 nm

Um hier auf eine größere Stärke der Titanschicht zu kommen, kann die Häufigkeit der Zirkoniumschicht verdoppelt werden. Die Schichtfolge ist dann ... Ti, Zr, Ni, Zr, Ti, Zr, Ni, Zr, ... mit den folgenden Schichtstärkenverhältnissen:
d_{Zr} = 5 nm; d_{Ni} = 2,0 nm und d_{Ti} = 0,8 nm

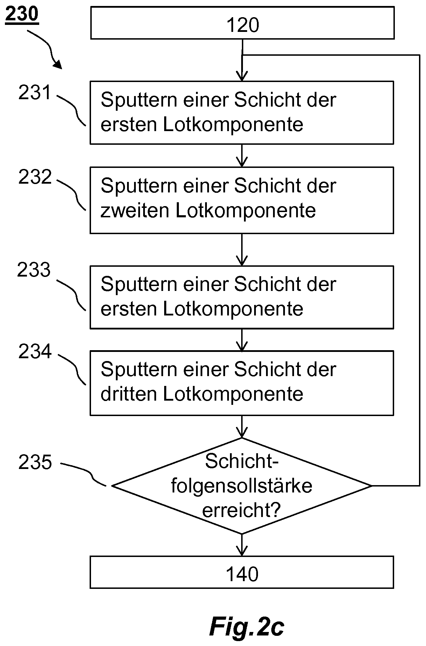

Ein entsprechender Teilprozess für den Beschichtungsschritt 230 ist in Fig. 2c dargestellt, wobei Zr der ersten Komponente entspricht, während Ni und Ti die zweite bzw. dritte Komponente bilden.

Um eine effiziente Abscheidungsrate mit hinreichend guter Kontrolle der Rate zu erzielen, wird bevorzugt eine Sputteranlage mit einem Hochleistungsmagnetron eingesetzt. Damit lassen sich kontrolliert Abscheidungsraten zwischen beispielsweise etwa 0,2 nm/s bis etwa 2 nm/s einstellen. Für das Abscheiden der 5 µm werden bei einer Abscheidungsrate von 2 nm/s dann 2500 s also knapp 42 Minuten benötigt.

## Patentansprüche

1. Verfahren zum Herstellen einer Verbindung zwischen zwei Oberflächen oder Oberflächenabschnitten zweier Keramikteile, umfassend:
Bereitstellen (110) eines ersten Keramikteils und eines zweiten Keramikteils;
Bereitstellen (130) eines Aktivhartlotmaterials auf zumindest einem Oberflächenabschnitt zumindest eines der Keramikteile, wobei das Aktivhartlot eine Zr-Ni-Ti-Legierung aufweist; und
Erhitzen des Aktivhartlots in einem Vakuumlötprozess,
wobei das gesamte Aktivhartlotmaterial zum Verbinden des ersten und des zweiten Keramikteils durch ein Sputterverfahren (130) bereitgestellt wird,
**dadurch gekennzeichnet, dass**
zumindest ein Oberflächenabschnitt zumindest eines der Keramikteile, vorzugsweise beider Keramikteile, mit einer Schichtfolge (131, 132, 133) der einzelnen Komponenten des Aktivhartlotmaterials beschichtet wird, wobei Zr, Ni, und Ti jeweils eine der einzelnen Komponenten bilden,
wobei die mittlere Stärke der Schichten einer einzelnen Komponente des Aktivhartlots nicht mehr als 0,5 %, insbesondere nicht mehr als 0,2%, vorzugsweise nicht mehr als 0,1% und besonders bevorzugt nicht mehr als 0,05% der Stärke der Fügestelle beträgt.

2. Verfahren nach Anspruch 1, wobei das Aktivhartlot in der Fügestelle eine Stärke von nicht mehr als 20 µm, insbesondere nicht mehr als 15 µm, bevorzugt nicht mehr als 12 µm und besonders bevorzugt nicht mehr als 10 µm aufweist.

3. Verfahren nach Anspruch 1 oder 2, wobei die einzelnen Schichten der Komponente eine Stärke von nicht mehr als 10 nm, insbesondere nicht mehr als 5 nm, vorzugsweise nicht mehr als 2 nm und besonders bevorzugt nicht mehr als 1 nm aufweisen.

4. Verfahren nach einem der vorhergehenden Ansprüche, wobei die mittlere Schichtstärke der Schichten einer Komponente und/oder deren Häufigkeit eine Funktion des Anteils der Komponente an der Legierung ist.

5. Verfahren nach einem der vorhergehenden Ansprüche, wobei die mittlere Schichtstärke der Schichten einer Komponente proportional zum Anteil der Komponente an der Legierung ist.

6. Verfahren nach einem der vorhergehenden Ansprüche, wobei die Komponenten jeweils von reinen Sputtertargets gesputtert werden, die jeweils ausschließlich das Material der Komponente aufweisen.

7. Verfahren nach einem der vorhergehenden Ansprüche, wobei die Stärke der einzelnen Schichten über die jeweilige Beschichtungszeit in Abhängigkeit von der Depositionsrate der einzelnen Komponenten gesteuert wird.

8. Verfahren nach einem der vorhergehenden Ansprüche, wobei die Depositionsrate der einzelnen Komponenten jeweils mittels einer Quarzwaage überwacht wird.

9. Verfahren nach einem der vorhergehenden Ansprüche, wobei auf der mindestens einen Oberfläche zunächst eine erste Schichtfolge einer ersten Zusammensetzung der Komponenten des Aktivhartlots abgeschieden wird,
wobei auf die erste Schichtfolge eine zweite Schichtfolge einer zweiten Zusammensetzung der Komponenten des Aktivhartlots folgt,
wobei die erste Zusammensetzung insbesondere einen Schmelzpunkt aufweist, der nicht weniger als 100 K niedriger ist als der Schmelzpunkt der zweiten Zusammensetzung.

10. Verfahren nach Anspruch 9, wobei die zweite Zusammensetzung einen Wärmeausdehnungskoeffizenten aufweist, der eine geringere Differenz zum Wärmeausdehnungskoeffizienten des keramischen Werkstoffs aufweist als der Wärmeausdehnungskoeffizient der ersten Zusammensetzung.

11. Verfahren nach Anspruch 9 oder 10, wobei die erste Schichtfolge eine Stärke aufweist, die nicht mehr als 10%, insbesondere nicht mehr als 5% der Stärke der Fügestelle beträgt.

12. Verfahren nach einem der vorhergehenden Ansprüche, wobei eine erste Schicht, mit welcher zumindest einer der Fügepartner beschichtet wird, eine aktive Komponente des Aktivhartlots aufweist.

13. Verfahren nach Anspruch 12, wobei die mindestens eine aktive Komponente Titan oder Zirkon umfasst.

14. Verfahren nach einem der vorhergehenden Ansprüche, wobei das erste und/oder zweite Keramikteil Korund aufweisen.

15. Verfahren nach einem der vorhergehenden Ansprüche, wobei das erste Keramikteil und das zweite Keramikteil entlang einer ringförmigen Fügestelle, welche einen Hohlraum zwischen dem ersten Keramikteil und dem zweiten Keramikteil umschließt, druckdicht verbunden werden,
wobei das Aktivhartlot auf mindestens einem ringförmigen Oberflächenabschnitt eines Keramikteils abgeschieden wird,
wobei ein von dem ringförmigen Oberflächenabschnitt umschlossener Bereich während des Abscheidens des Aktivhartlots maskiert ist.

16. Verfahren nach einem der vorhergehenden Ansprüche, wobei das erste keramische Teil einen Grundkörper des Drucksensors umfasst,
wobei das zweite keramische Teil die Messmembran des Drucksensors umfasst, und
wobei die Messmembran mit dem Grundkörper entlang einer ringförmigen Fügestelle, welche das Aktivhartlot aufweist, druckdicht verbunden werden.

17. Verfahren nach Anspruch 16, wobei der Drucksensor ein Differenzdrucksensor ist, welcher eine Messmembran zwischen zwei Grundkörpern oder einen Grundkörper zwischen zwei Messmembranen aufweist, die miteinander zu fügen sind, wobei das Aktivhartlotmaterial für die beiden Fügestellen zwischen der Messmembran und den Gegenkörpern bzw. den Messmembranen und dem Gegenkörper jeweils in gleicher Weise bereitgestellt wird.

## Claims

1. Procedure for establishing a connection between two surfaces or surface sections of two ceramic parts, comprising:
the provision (110) of a first ceramic part and a second ceramic part;
the provision (130) of an active brazing solder material on at least one surface section of at least one of the ceramic parts, wherein the active brazing solder features a Zr-Ni-Ti alloy; and
heating of the active brazing solder in a vacuum solder process, wherein the entire active brazing solder material to connect the first and the second ceramic part is provided by a sputtering process (130),
**characterized in that**
at least one surface section of at least one of the ceramic parts, preferably of both ceramic parts, is coated with a series of layers (131, 132, 133) of the individual components of the active brazing solder, wherein Zr, Ni and Ti each form one of the individual components,
wherein the average thickness of the layers of the individual components of the active brazing solder is not more than 0.5 %, particularly not more than 0.2 %,
preferably not more than 0.1 % and particularly preferably not more than 0.05 % of the thickness of the joint.

2. Procedure as claimed in Claim 1, wherein the active brazing solder in the joint has a thickness of not more than 20 µm, particularly not more than 15 µm, preferably not more than 12 µm and particularly preferably not more than 10 µm.

3. Procedure as claimed in Claim 1 or 2, wherein the individual layers of the components have a thickness of not more than 10 nm, particularly not more than 5 nm, preferably not more than 2 nm and particularly preferably not more than 1 nm.

4. Procedure as claimed in one of the previous claims, wherein the average layer thickness of the layers of a component and/or their frequency is a function of the share of the component in the alloy.

5. Procedure as claimed in one of the previous claims, wherein the average layer thickness of the layers of a component is proportional to the share of the component in the alloy.

6. Procedure as claimed in one of the previous claims, wherein the components are sputtered in each case by pure sputter targets that only feature the material of the component in each case.

7. Procedure as claimed in one of the previous claims, wherein the thickness of the individual layers is controlled over the coating time depending on the deposition rate of the individual components.

8. Procedure as claimed in one of the previous claims, wherein the deposition rate of the individual components is monitored in each case by a quartz balance.

9. Procedure as claimed in one of the previous claims, wherein a first layer series of a first composition of the components of the active brazing solder is first deposited on the at least one surface,
wherein a second layer series of a second composition of the components of the active brazing solder follows the first layer series,
wherein the first composition in particular has a melting point that is not less than 100 K lower than the melting point of the second composition.

10. Procedure as claimed in Claim 9, wherein the second composition has a thermal expansion coefficient that has a smaller difference in relation to the thermal expansion coefficient of the ceramic material than the thermal expansion coefficient of the first composition.

11. Procedure as claimed in Claim 9 or 10, wherein the first layer series has a thickness that is not more than 10 %, particularly not more than 5 % of the thickness of the joint.

12. Procedure as claimed in one of the previous claims, wherein a first layer with which at least one of the joining members is coated features an active component of the active brazing solder.

13. Procedure as claimed in Claim 12, wherein the at least one active component is titanium or zirconium.

14. Procedure as claimed in one of the previous claims, wherein the first and/or second ceramic part comprise corundum.

15. Procedure as claimed in one of the previous claims, wherein the first ceramic part and the second ceramic part are connected in a pressure-tight manner along a circular joint, which surrounds a cavity between the first ceramic part and the second ceramic part,
wherein the active brazing solder is deposited on at least one circular surface section of a ceramic part,
wherein an area enclosed by the circular surface section is masked while the active brazing solder is deposited.

16. Procedure as claimed in one of the previous claims, wherein the first ceramic part comprises a meter body of the pressure sensor,
wherein the second ceramic part comprises the measuring diaphragm of the pressure sensor, and
wherein the measuring diaphragm is connected to the meter body in a pressure-tight manner along a circular joint which features the active brazing solder.

17. Procedure as claimed in Claim 16, wherein the pressure sensor is a differential pressure sensor which features a measuring diaphragm between two meter bodies or a meter body between two measuring diaphragms, which are to be joined together, wherein the active brazing solder material for the two joints between the measuring diaphragm and the counter-bodies or between the measuring diaphragms and the counter-body is provided in the same way in both cases.

## Revendications

1. Procédé destiné à la fabrication d'une liaison entre deux surfaces ou parties de surface de deux pièces de céramique,
comprenant :
Mise à disposition (110) d'une première pièce de céramique et d'une deuxième pièce de céramique ;
Mise à disposition (130) d'un métal d'apport de brasage fort sur au moins une partie de la surface d'au moins l'une des deux pièces de céramique, le métal d'apport de brasage fort présentant un alliage Zr-Ni-Ti ; et
Échauffement du métal d'apport de brasage fort dans un process de soudage sous vide,
la totalité du métal d'apport de brasage fort étant mise à disposition pour la liaison de la première et de la deuxième pièce de céramique au moyen d'un procédé de pulvérisation (130),
**caractérisé**
**en ce qu'**au moins une partie de la surface d'au moins l'une des pièces de céramique, de préférence des deux pièces de céramique, est revêtue avec une succession de couches (131, 132, 133) des différents composants du métal d'apport de brasage fort, du Zr, du Ni et du Ti formant respectivement les différents composants,
l'épaisseur moyenne des couches d'un composant individuel du métal d'apport de brasage fort étant inférieure ou égale à 0,5 %, notamment inférieure ou égale à 0,2 %, de préférence inférieure ou égale à 0,1 % et particulièrement de préférence inférieure ou égale à 0,05 % de l'épaisseur du point de jonction.

2. Procédé selon la revendication 1, pour lequel le métal d'apport de brasage fort présente, au niveau du point de jonction, une épaisseur inférieure ou égale à 20 µm, notamment inférieure ou égale à 15 µm, de préférence inférieure ou égale à 12 µm et particulièrement de préférence inférieure ou égale à 10 µm.

3. Procédé selon la revendication 1 ou 2, pour lequel les différentes couches du composant présentent une épaisseur inférieure ou égale à 10 nm, notamment inférieure ou égale à 5 nm, de préférence inférieure ou égale à 2 nm et particulièrement de préférence inférieure ou égale à 1 nm.

4. Procédé selon l'une des revendications précédentes, pour lequel l'épaisseur moyenne des couches d'un composant et/ou leur fréquence est une fonction de la proportion du composant dans d'alliage.

5. Procédé selon l'une des revendications précédentes, pour lequel l'épaisseur moyenne des couches d'un composant est proportionnelle à la part du composant dans l'alliage.

6. Procédé selon l'une des revendications précédentes, pour lequel les composants sont pulvérisés respectivement par des cibles de pulvérisation pures, qui présentent exclusivement le matériau du composant.

7. Procédé selon l'une des revendications précédentes, pour lequel l'épaisseur des différentes couches est régie par le temps de revêtement respectif en fonction du taux de dépôt des différents composants.

8. Procédé selon l'une des revendications précédentes, pour lequel le taux de dépôt des différents composants est surveillé respectivement au moyen d'une balance à quartz.

9. Procédé selon l'une des revendications précédentes, pour lequel une première succession de couches d'une première composition des composants du métal d'apport de brasage fort est dans un premier temps déposée sur l'au moins une surface,
la première succession de couches étant suivie par une deuxième succession de couches d'une deuxième composition des composants du métal d'apport de brasage fort,
la première composition présentant notamment un point de fusion qui n'est pas inférieur de moins de 100 K au point de fusion de la deuxième composition.

10. Procédé selon la revendication 9, pour lequel la deuxième composition présente un coefficient de dilatation thermique, qui présente une différence avec le coefficient de dilatation thermique du matériau céramique inférieure au coefficient de dilatation thermique de la première composition.

11. Procédé selon la revendication 9 ou 10, pour lequel la succession de couches présente une épaisseur, qui est inférieure ou égale à 10 %, notamment inférieure ou égale à 5 % de l'épaisseur du point de jonction.

12. Procédé selon l'une des revendications précédentes, pour lequel une première couche, avec laquelle l'un des éléments à assembler est revêtu, présente un composant actif du métal d'apport de brasage fort.

13. Procédé selon la revendication 12, pour lequel l'au moins un composant actif comprend du titane ou du zircon.

14. Procédé selon l'une des revendications précédentes, pour lequel la première et/ou la deuxième pièce de céramique comprend du corindon.

15. Procédé selon l'une des revendications précédentes, pour lequel la première pièce de céramique et la deuxième pièce de céramique est reliée de façon étanche à la pression, le long d'un point de jonction annulaire, qui renferme un espace creux entre la pièce de céramique et la deuxième pièce de céramique,
le métal d'apport de brasage fort étant déposé sur au moins une partie de surface annulaire d'une pièce de céramique,
une zone entourée par la partie de surface annulaire étant masquée pendant le dépôt du métal d'apport de brasage fort.

16. Procédé selon l'une des revendications précédentes,
pour lequel la première pièce de céramique comprend un corps de base du capteur de pression,
pour lequel la deuxième pièce de céramique comprend la membrane de mesure du capteur de pression, et
pour lequel la membrane de mesure est reliée de façon étanche à la pression, le long d'un point de jonction annulaire, qui comprend le métal d'apport de brasage fort.

17. Procédé selon la revendication 16, pour lequel le capteur de pression est un capteur de pression différentielle, lequel présente une membrane de mesure entre deux corps de base ou un corps de base entre deux membranes de mesure, qui doivent être assemblés, le métal d'apport de brasage fort étant mis à disposition de la même manière pour les deux points de jonction entre la membrane de mesure et les contre-corps ou les membranes de mesure et le contre-corps.
